Europäisches Patentamt

European Patent Office

Office européen des brevets

(19)

(11) Veröffentlichungsnummer: **0 226 804 B1**

## (12) EUROPÄISCHE PATENTSCHRIFT

(45) Veröffentlichungstag der Patentschrift: **29.05.91**

(51) Int. Cl.⁵: **H01J 37/20**

(21) Anmeldenummer: **86115774.1**

(22) Anmeldetag: **13.11.86**

(54) **Goniometertisch.**

(30) Priorität: **24.12.85 DE 3546095**

(43) Veröffentlichungstag der Anmeldung:
**01.07.87 Patentblatt 87/27**

(45) Bekanntmachung des Hinweises auf die
Patenterteilung:
**29.05.91 Patentblatt 91/22**

(84) Benannte Vertragsstaaten:
**DE NL**

(56) Entgegenhaltungen:
**JP-A-60 230 345**
**US-A- 3 896 314**
**US-A- 4 405 865**

**"Philips Technische Rundschau", 29 Jg., nr
11/12 (1968), Seiten 378-395**

(73) Patentinhaber: **Firma Carl Zeiss**

**W-7920 Heidenheim (Brenz)(DE)**

(72) Erfinder: **Egle, Wilhelm**
**Heulenbergweg 30**
**W-7080 Aalen(DE)**
Erfinder: **Gütter, Ernst, Dr.**
**Wacholderweg 19**
**W-7923 Königsbronn(DE)**
Erfinder: **Rösner, Hartmut**
**Barbarossastrasse 14**
**W-7087 Essingen(DE)**

## Beschreibung

Die vorliegende Erfindung betrifft einen Goniometertisch, vorzugsweise für Elektronenmikroskope, mit einer Lagerhülse zur Aufnahme eines Objekthalterstabes mit einer Kippvorrichtung zum Kippen der Lagerhülse und des Objekthalterstabes um eine Kippachse, wobei die Kippvorrichtung aus einem im Objektivblock angeordneten Innenlager mit einem kugelförmigen Gelenkkopf und aus einem an der Mikroskopwand angeordneten Außenlager mit einem um die Zylinderachse drehbaren Zylinder aufgebaut ist, wobei ferner durch Justiervorrichtungen eine Justierung des Zylinders und der Kippachse möglich ist, und mit Einstellvorrichtungen zum Einstellen eines Ausschnittes vom Objekt, welche gemeinsam mit der Kippvorrichtung drehbar sind.

Bei elektronenmikroskopischen Untersuchungen ist es oft notwendig, das Objekt nicht nur in der sog. Scharfstellebene verschieben zu können, sondern auch um eine Achse kippen zu können, die senkrecht auf der optischen Achse des Elektronenmikroskops steht. Dafür geeignete Objekthalter werden meist als Goniometer(präparat)tisch (englisch goniometer plate) bezeichnet. Bei der Benutzung derartiger Einrichtungen ist es natürlich vorteilhaft, wenn bei einer Kippung des Objektes sowohl der Ausschnitt vom Objekt als auch die Scharfeinstellung erhalten bleibt. Um dies zu erreichen muß die Achse, um welche die Kippung erfolgt, die optische Achse des Elektronenmikroskopes in der Scharfstellebene schneiden. Eine derartige Achse wird als euzentrische Achse bezeichnet. Auf ihr liegende Objektpunkte bleiben bei einer Kippung des Objektes in ihrer räumlichen Lage unverändert, d.h. wenn die euzentrische Achse richtig eingestellt ist und somit der gewünschte Ausschnitt des Objektes zur Scharfeinstellung durch geeignete Einstellvorrichtungen des Goniometertisches zwangsläufig auf den Schnittpunkt zwischen optischer und euzentrischer Achse gebracht wird, dann bleiben bei einer Kippung des Objektes um die euzentrische Achse die Scharfeinstellung und der Objektausschnitt erhalten, bzw. sind nur noch von der Genauigkeit der mechanischen Ausführung abhängig, sofern die Einstellrichtungen mit der Einrichtung zur Kippung gemeinsam gedreht werden.

Aus einer Veröffentlichung (Philips Technische Rundschau 29, 378 (1968)) ist ein Goniometertisch bekannt, bei dem der Objekthalterstab in einer Lagerhülse sitzt, die an ihrem dem Objekt zugewandten Ende mit einem kugelförmigen Gelenkkopf ausgebildet ist. Dieser Gelenkkopf ist in der Schale eines Innenlagers bewegbar, das mit dem Objektivblock des Elektronenmikroskopes fest verbunden ist. Das andere Ende der Lagerhülse ist über zwei Einstellvorrichtungen für zwei zueinander senkrechte Richtungen (y, z) in einem drehbaren Zylinder gelagert, welcher über ein Außenlager und ein Rohr mit der Mikroskopsäule verbunden ist. Bei einer Drehung des Zylinders wird über die Einstellvorrichtungen die Lagerhülse mitgedreht und damit der Objekthalterstab gekippt. Die Kippachse wird durch die Achse des Zylinders bestimmt, welche auf den Mittelpunkt des Innenlagers ausgerichtet ist. Die Bewegung des Objektes in der dritten Raumkoordinate (x) erfolgt durch Verschieben des Objekthalterstabes in der Lagerhülse über eine Mikrometerspindel und einen Pendelstab auf der der Kippvorrichtung gegenüber liegenden Seite des Objektivgehäuses.

Nachteilig bei diesem bekannten Goniometertisch ist, daß die Kippachse in der horizontalen Ebene nur durch Verschieben der gesamten Einrichtung gegenüber der elektronenoptischen Achse des Objektivs ausgerichtet werden kann. Die Höhenjustierung der Kippachse in die Scharfstellebene des Objektivs erfolgt durch mechanischen Abgleich (Abstimmung bei der Montage) im Objektivblock. Da die Mikrometerspindel ebenfalls nicht zur Kippachse justierbar ist, entscheidet die Herstellgenauigkeit über die Erhaltung der x-Koordinate während der Kippung. Sehr ungünstig ist, daß die Drehung der Lagerhülse über die Einstellvorrichtungen für die y- und z-Richtung erfolgt, was die Genauigkeit der Einstellungen beeinflußt und dazu führt, daß bei starken Vergrößerungen (größer als 100 000 x) der eingestellte Ausschnitt des Objektes bei Kippung um große Winkel (>45−) vom Leuchtschirm des Elektronenmikroskops verschwindet.

Aus der US-PS 4 405 865 ist ein Goniometertisch bekannt, der ebenfalls ein kugelförmiges Innenlager im Objektivblock hat. In diesem Lager wird ein Rohr bewegt, das an seinem äußeren Ende in einer Kugelführungsbuchse drehbar gelagert ist. Die Kugelführungsbuchse ist über eine Membrane mit einer Fassung verbunden, welche auf einer Planfläche der Mikroskopsäule verschiebbar ist und damit eine Justierung der Kippachse in zwei zueinander senkrechten Richtungen (y, z) erlaubt. Das um die Kippachse drehbare Rohr ist an seinem äußeren Ende über Einstellvorrichtungen für zwei zueinander senkrechte Richtungen (y, z) mit einer Lagerhülse verbunden, welche in der Nähe des kugelförmigen Innenlagers über eine Innenmembrane eine weitere Verbindung mit dem Rohr hat und somit durch die Einstellvorrichtungen um den Mittelpunkt dieser Membrane geschwenkt werden kann. Durch eine weitere Einstellvorrichtung kann die Lagerhülse infolge der Innenmembrane auch in der Richtung (x) der zur Membranoberfläche senkrechten Achse, d.h. in Richtung der Längsachse der Lagerhülse verstellt werden.

Nachteilig bei diesem Goniometertisch ist, daß die Einstellvorrichtungen für die y- und z-Richtung aus fest angekoppelten Gelenkverbindungen bestehen, so daß sich die Einstellungen gegenseitig beeinflussen. Außerdem ist der Membranmittelpunkt nicht exakt definiert. Die Einstellung für die x-Richtung ist infolge der großen Länge des Übertragungsweges sehr ungünstig in Bezug auf mechanische und thermische Stabilität. Zudem ist die Verstellbarkeit in x-Richtung durch die begrenzte Auslenkbarkeit der Innenmembrane relativ klein.

Schließlich ist aus der JP-A-60 230 345 ein Goniometertisch für ein Raster-Elektronenmikroskop bekannt, bei dem ein drehbarer Zylinder an der Außenwand des Rasterelektronenmikroskopes in Höhe und Seite verstellbar angeordnet ist. In der Achse dieses Zylinders ist eine Lagerhülse angeordnet, die auf der zum Präparat gerichteten Seite des drehbaren Zylinders in einem kugelförmigen Lager gelagert ist. Auf der anderen Seite des Zylinders wird die Lagerhülse von zwei kreuztischförmig ausgebildeten Einstellvorrichtungen gehalten, die eine Verstellung in Höhe und Seite gestatten.

Dieser bekannte Goniometertisch hat folgende Nachteile: Die Lagerung des drehbaren Zylinders, der hier allein die Kippachse bestimmt, hat nur eine geringe Breite; dadurch kann die euzentrische Achse für ein hochauflösendes Transmissions-Elektronenmikroskop nicht ausreichend konstant eingestellt werden. Der Drehpunkt für die Lagehülse liegt im drehbaren Zylinder weit entfernt vom Präparat und sein Abstand von den Einstellvorrichtungen ist verhältnismäßig klein, so daß die Einstellung der euzentrischen Achse für hochauflösende Transmissions-Elektronenmikroskope nicht ausreichend genau möglich ist.

Der vorliegenden Erfindung liegt daher die Aufgabe zugrunde, einen Goniometertisch zu schaffen, der auch für hochauflösende Transmissions-Elektronenmikroskope eine leichte und genaue Justierung der Kippachse ermöglicht und der Einstellvorrichtungen für den gewünschten Objektausschnitt hat, die präzise, mechanisch und thermisch stabile Objektverschiebungen ermöglichen und die so ausgeführt sind, daß Objektausschnitt und Scharfeinstellung während der Kippung auch bei starker Vergrößerung und großem Kippwinkel erhalten bleiben.

Die gestellte Aufgabe wird erfindungsgemäß dadurch gelöst, daß Lagerhülse und kugelförmiger Gelenkkopf fest miteinander verbunden sind, daß der kugelförmige Gelenkkopf mit dem Zylinder des Außenlagers nicht starr verbunden ist, so daß die Justierung des Zylinders mittels der Justiervorrichtungen unabhängig vom Innenlager ist, daß die Lagerhülse durch die Einstellvorrichtungen um den Mittelpunkt des kugelförmigen Gelenkkopfes verstellbar ist und daß die Lagerhülse über einen torsionssteifen Balg mit dem drehbaren Zylinder verbunden ist.

In einer besonders vorteilhaften Ausführungsform sind die Einstellvorrichtungen für die y- und z-Richtung weder von der Kippung um die Kippachse noch voneinander abhängig. Dies läßt sich z.B. dadurch erreichen, daß die Einstellvorrichtungen als exakte Kreuztischführung ausgebildet sind, wobei die Spindeln für die y- und die z-Einstellung in einer Ebene liegen und exakt senkrecht zueinander angeordnet sind.

In einer weiteren vorteilhaften Ausgestaltung der Erfindung liegen die Angriffspunkte der Einstellvorrichtungen für die y- und z-Richtung möglichst nahe am Außenlager für die Drehbewegung um die Kippachse.

Besonders gute Eigenschaften des erfindungsgemäßen Goniometertisches werden dadurch erreicht, daß die Einstellvorrichtungen für die y- und z-Richtung in ihren Baulängen sehr kurz gehalten sind, daß sie bei Drehbewegungen um die Kippachse vollständig mitgedreht werden und daß sie infolge des Balges zwischen drehbarem Zylinder und Lagerhülse nicht zur Übertragung der Drehbewegung auf die Lagerhülse benutzt werden.

Weitere vorteilhafte Ausgestaltungen der Erfindung gehen aus den Unteransprüchen und aus den Erläuterungen zu den Figuren hervor.

Die Erfindung wird im folgenden anhand eines in den Figuren 1 bis 3 dargestellten Ausführungsbeispieles näher erläutert. Dabei zeigen:

Fig. 1     einen vertikalen Schnitt durch den Goniometertisch;

Fig. 2     einen horizontalen Schnitt durch den Goniometertisch und

Fig. 3     einen vertikalen Schnitt durch die Einstellvorrichtungen für die y- und z-Richtung.

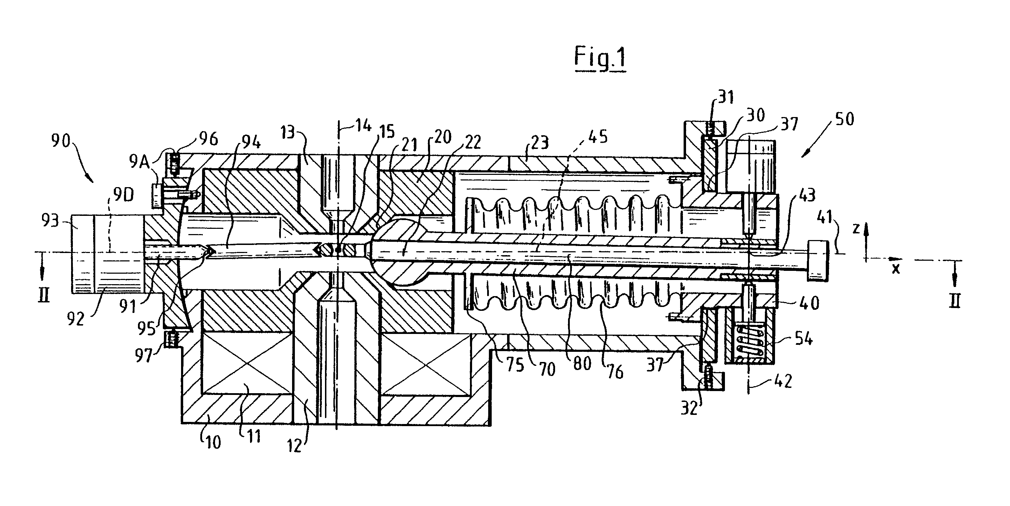

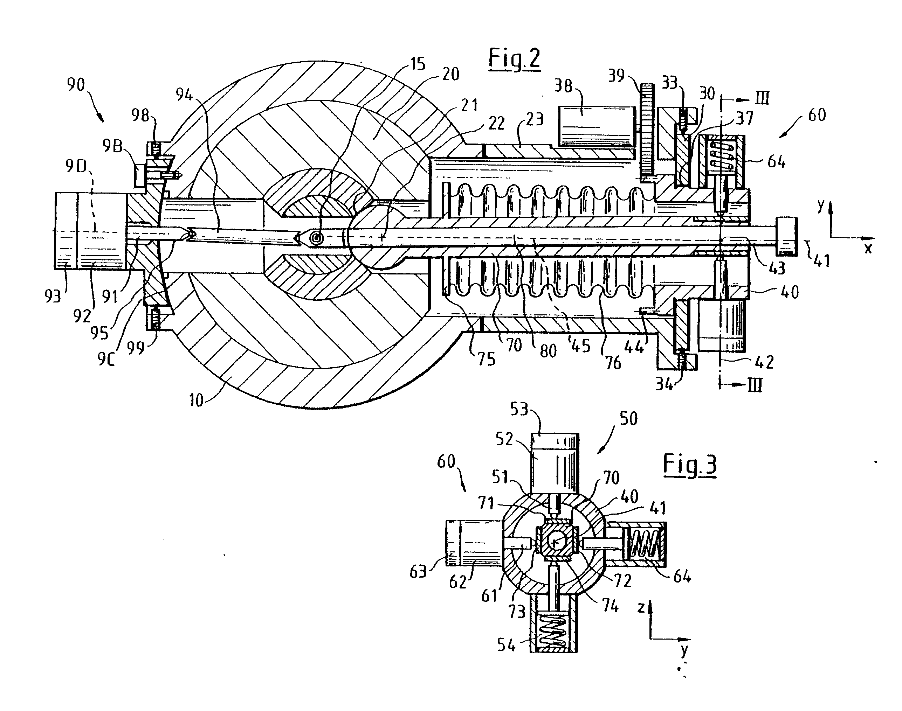

In den Figuren 1 und 2 ist mit 10 das Gehäuse vom Objektiv eines Elektronenmikroskopes bezeichnet. Mit der stromdurchflossenen Spule 11 wird zwischen den Polschuhen 12 und 13 das für die Abbildung des Objektes 15 ertorderliche Magnetfeld erzeugt. Die Richtung der optischen Achse 14 der Objektivlinse liegt entsprechend den auf der rechten Seite der Figuren angegebenen Koordinatenrichtungen - wie allgemein üblich - in der z-Richtung. Der Goniometertisch ist mit dem Objektiv fest verbunden über den Objektivblock 20, der ein Innenlager 21 besitzt. In der Schale dieses Innenlagers kann der kugelförmige Gelenkkopf der Lagerhülse 70 um den Mittelpunkt 22 bewegt werden.

Der Objektivblock 20 des Goniometertisches ist fest mit dem Gehäuse 23 verbunden, an welchem die Lagerscheibe 30 befestigt ist. Letztere kann durch Justierschrauben 31 und 32 sowie 33 und 34 in der y-z-Ebene justiert und mit nicht gezeichneten Schrauben fixiert werden. (In den Figuren 1 und 2 ist die Lagerscheibe absichtlich in einer übertriebenen Extremstellung gezeichnet, um die Lage verschiedener Achsen darstellen zu können.) Die Lagerscheibe 30 hat in ihrem Zentrum ein genau geschliffenes Gleitlager 37. In diesem Gleitlager sitzt drehbar der Zylinder 40, der gegen Verschiebungen in der x-Richtung durch zwei nicht gezeichnete Axialrollenlager gesichert ist. Der Zylinder kann z.B. durch den auf der Lagerscheibe 30 befestigten Motor 38 über das Zahnrad 39 und den Zahnkranz 44 um seine Achse 41 gedreht werden.

Der Zylinder 40 ist mit dem äußeren Ende der Lagerhülse 70 - wie besonders aus Figur 3 zu sehen ist - über eine exakte Kreuztischführung verbunden, die eine Verstellung der Lagerhülse 70 in y-Richtung und in z-Richtung ohne gegenseitige Beeinflussung gewährleistet. In dem dargestellten Ausführungsbeispiel besteht die Kreuztischführung aus zwei elektromotorischen Antrieben 52 und 62 für die Bewegung der Spindeln 51 und 61 in y- und z-Richtung und federnden Rückstellern 54 und 64, die auf die exakt rechtwinklig zueinander angeordneten Flächen 71, 72, 73 und 74 der Lagerhülse 70 wirken. Die Antriebe 52 und 62 sind direkt mit Stellungsgebern 53 und 63 zur Übertragung der Einstellungen verbunden. Durch die Einstellvorrichtungen 50 und 60 wird die Lagerhülse 70 um den Mittelpunkt 22 des Innenlagers 21 in der y- und der z-Richtung verstellt.

Die Lagerhülse 70 ist außerdem über die Scheibe 75 und den Balg 76 mit dem Zylinder 40 verbunden. Dieser Balg, der vorzugsweise aus Metall ist, überträgt infolge seiner Torsionssteifigkeit die Drehbewegung des Zylinders 40 schlupf- und spielfrei auf die Lagerhülse 70; er ist jedoch für angulare und laterale Auslenkungen genügend flexibel, um die Einstellung der Lagerhülse 70 in y- und z-Richtung zu ermöglichen. Da die Drehbewegung des Zylinders 40 über den Balg 76 unmittelbar auf die Lagerhülse 70 übertragen wird, werden bei einer Drehbewegung nicht die Einstellvorrichtungen 50 und 60 belastet, die sonst die Drehbewegung übertragen müßten und damit in ihrer Genauigkeit und Reproduzierbarkeit negativ beeinflußt würden.

Die Angriffspunkte der Einstelleinrichtungen 50 und 60 an der Lagerhülse 70 liegen möglichst nahe an der Lagerscheibe 30, damit Taumelfehler des Außenlagers 37 einen möglichst geringen Einfluß haben. Über (in den Figuren nicht dargestellte) Kipphebel läßt sich erreichen, daß die Angriffspunkte in die Ebene der Lagerscheibe 30 gelegt werden. Außerdem ist es günstig, die Einstelleinrichtungen 50 und 60 bezüglich der Achse 41 des Zylinders 40 (statisch) auszuwuchten, so daß bei einer Drehbewegung des Zylinders 40 keine Änderungen der Kräfte im Außenlager 37 entstehen. Für die Genauigkeit und Reproduzierbarkeit der Einstellungen ist besonders vorteilhaft, daß die Einstellvorrichtungen 50 und 60 mit kurzen, thermisch unempfindlichen und mechanisch stabilen Spindeln 51 und 61 ausgerüstet sind.

Bei einer Drehung des Zylinders 40 werden die Lagerhülse 70 und die Einstellvorrichtungen 50 und 60 um die Kippachse 45 gedreht, welche durch den Mittelpunkt 22 des Innenlagers 21 und den Schnittpunkt 43 der Achse 41 des Zylinders 40 mit der Ebene 42, in welcher die Einstellvorrichtungen 50 und 60 ihre Angriffspunkte an der Lagerhülse 70 haben, geht.

In der Lagerhülse 70 ist axial beweglich der Objekthalterstab 80 untergebracht, an dessen inneren Ende das Objekt 15 sitzt. Zum Einbringen des Objektes in das Vakuum und zum Ausschleusen aus dem Vakuum ist innerhalb der Lagerhülse 70 eine in den Figuren nicht dargestellte Vakuumschleuse in bekannter Ausführung untergebracht. In dem kugelförmigen Gelenkkopf der Lagerhülse 70 wird der Objekthalterstab 80 durch eine (nicht gezeichnete) Feder gegen ein (nicht gezeichnetes) V-Lager gedrückt, damit er kein radiales Spiel hat und dadurch bei einer Drehung der Lagerhülse 70 nicht durch die Schwerkraft in seiner Lage zur Lagerhülse beeinflußt wird.

Die Einstellung des Objektes in x-Richtung erfolgt durch eine Verschiebung des Objekthalterstabes 80 in der Lagerhülse 70 durch die Einstellvorrichtung 90, welche auf der der Kippvorrichtung gegenüberliegenden Seite des Goniometertisches liegt und die gegen den von außen auf den Objekthalterstab 80 wirkenden Luftdruck arbeitet. Sie besteht aus einer Spindel 91, die z.B. von einem elektromotorischen Antrieb 92 mit einem Stellungsgeber 93 bewegt wird, und einem Pendeistab 94, der die Axialbewegung der Spindel 91 auf den Objekthalterstab 80 überträgt, und der bei Auslenkung des Objekthalterstabes 80 aus der Mittelstellung durch die y- und z-Einstellung und bei der Kippung eine Bewegung auf einem Kegelmantel um die Kippachse 45 beschreibt. Die Einstelleinrichtung 90 wird relativ zum Gehäuse 10 bzw. zum Objektivblock 20 so justiert, daß das Zentrum der Kugel 95 an der Spitze der Spindel 91 exakt auf der Kippachse 45 bzw. der euzentrischen Achse liegt. Dazu ist die Einssteileinrichtung 90 in vertikaler Richtung mit den Justierschrauben 96 und 97 und in horizontaler Richtung mit den Justierschrauben 98 und 99 auf einer Kugelfläche 9C justierbar, deren Mittelpunkt mit dem Mittelpunkt 22 des Innenlagers 21 zusammenfällt. Bei richtiger Justierung liegt daher die Mittelachse 9D der Einstellvorrichtung 90 genau in der Verlängerung der Kippachse 45 bzw. der euzentrischen Achse. Die Justierung wird durch die Schrauben 9A und 9B fixiert.

Bei einer Drehung des Zylinders 40 wird das Objekt 15 im Strahlengang des Elektronenmikroskopes um die Kippachse 45 gekippt. Da die Lagerscheibe 30 in der z-Richtung und der y-Richtung - wie oben beschrieben - justierbar ist, kann die Kippachse 45 so eingestellt werden, daß sie die optische Achse 14 des Objektivs in der Scharfstellebene schneidet. Diese Kippachse wird als euzentrische Achse bezeichnet. Wenn in diesem Fall vom Objekt 15 ein bestimmter Ausschnitt durch die Einstelleinrichtungen 50, 60 und 90 in die Scharfstellebene und den Beobachtungsausschnitt des Elektronenmikroskopes gebracht wird, dann liegt der Ausschnitt auf der euzentrischen Achse und bei einer Kippung bleiben Scharfeinstellung und Ausschnitt des Objektes erhalten.

Durch die Justiervorrichtung für die Lagerscheibe 30 in z-Richtung (mit Hilfe der Schrauben 31 und 32) ist es möglich, die Objektivlinse des Elektronenmikroskopes auch mit verschiedenen Betriebszuständen zu betreiben, z.B. als Kondensor-Einfeld-Objektiv für optimalen STEM-Betrieb oder als sog. Second-Zone-Linse für optimalen TEM-Betrieb, und dabei die Kippachse 45 immer exakt auf den Schnittpunkt der Objektivachse mit der Scharfstellebene einzustellen, so daß sie zur euzentrischen Achse wird.

Die Einstellvorrichtungen 50, 60 und 90 können selbstverständlich nicht nur, wie in dem Ausführungsbeispiel angegeben, mit elektromotorischen Antrieben betätigt werden. Besonders einfach sind mechanische Antriebe mit Zählwerken als Stellungsanzeigen. Auch piezoelektrische, pneumatische oder hydraulische Antriebe können verwendet werden. Es ist auch möglich, die Einstellvorrichtungen mit Einrichtungen für eine Steuerung oder Regelung zu verbinden, so daß einmal festgelegte Ausschnitte des Objektes 15 leicht wieder eingestellt werden können oder das Objekt systematisch abgesucht werden kann.

**Ansprüche**

1. Goniometertisch, vorzugsweise für Elektronenmikroskope, mit einer Lagerhülse (70) zur Aufnahme eines Objekthalterstabes (80), mit einer Kippvorrichtung zum Kippen der Lagerhülse (70) und des Objekthalterstabes (80) um eine Kippachse (45), wobei die Kippvorrichtung aus einem im Objektivblock (20) angeordneten Innenlager (21) mit einem kugelförmigen Gelenkkopf und aus einem an der Mikroskopwand angeordneten Außenlager (37) mit einem um die Zylinderachse (41) drehbaren Zylinder (40) aufgebaut ist, wobei ferner durch Justiervorrichtungen (31-34) eine Justierung des Zylinders (40) und der Kippachse (45) möglich ist, und mit Einstellvorrichtungen (50, 60) zum Einstellen eines Ausschnittes vom Objekt (15), welche gemeinsam mit der Kippvorrichtung drehbar sind, dadurch gekennzeichnet, daß Lagerhülse (70) und kugelförmiger Gelenkkopf fest miteinander verbunden sind, daß der kugelförmige Gelenkkopf mit dem Zylinder (40) des Außenlagers (37) nicht starr verbunden ist, so daß die Justierung des Zylinders (40) mittels der Justiervorrichtungen (31-34) unabhängig vom Innenlager (21) ist, daß die Lagerhülse (70) durch die Einstellvorrichtungen (50, 60) um den Mittelpunkt (22) des kugelförmigen Gelenkkopfes verstellbar ist und daß die Lagerhülse (70) über einen torsionssteifen Balg (76) mit dem drehbaren Zylinder (40) verbunden ist.

2. Goniometertisch nach Anspruch 1, dadurch gekennzeichnet, daß die Einstellvorrichtungen (50, 60) für die y- und die z-Einstellung von der Kippung um die Kippachse (45) und voneinander unabhängig sind.

3. Goniometertisch nach Anspruch 2, dadurch gekennzeichnet, daß für die Einstellvorrichtungen (50, 60) eine Kreuztisch-Führung (Fig. 3) vorgesehen ist.

4. Goniometertisch nach einem der Ansprüche 1 bis 3, dadurch gekennzeichnet, daß die Angriffspunkte der Einstellvorrichtungen (50, 60) für die y- und z-Einstellung an der Lagerhülse (70) möglichst nahe am Außenlager (37) angeordnet sind.

5. Goniometertisch nach einem der Ansprüche 1 bis 4, dadurch gekennzeichnet, daß der Objekthalterstab (80) in dem kugelförmigen Gelenkkopf der Lagerhülse (70) in einem V-Lager gelagert ist und daß eine Feder zum Drücken des Objekthalterstabes (80) gegen das V-Lager vorgesehen ist.

6. Goniometertisch nach einem der Ansprüche 1 bis 5, dadurch gekennzeichnet, daß die Einstellvorrichtung (90) für die x-Einstellung zur Kippachse (45) auf einer Kugelfläche (9C) justierbar ist, deren Mittelpunkt im Mittelpunkt (22) des Innenlagers (21) angeordnet ist.

7. Goniometertisch nach einem der Ansprüche 1 bis 6, dadurch gekennzeichnet, daß für die Einstellvorrichtungen (50, 60, 90) mechanische, piezoelektrische, pneumatische Antriebe oder elektromotorische Antriebe (52, 62, 92) vorgesehen sind.

8. Goniometertisch nach einem der Ansprüche 1 bis 7, dadurch gekennzeichnet, daß zur Anzeige und Speicherung der Koordinaten des eingestellten Ausschnittes vom Objekt (15) an den Einstellvorrichtungen (50, 60, 90) Zählwerke, Impulsgeber oder Stellungsgeber (53, 63, 93) vorgesehen sind.

9. Goniometertisch nach Anspruch 8, dadurch gekennzeichnet, daß die Einstellvorrichtungen (50, 60, 90) und die Stellungsgeber (53, 63, 93) mit einer Einrichtung zur Steuerung oder Regelung verbunden sind.

10. Goniometertisch nach einem der Ansprüche 1 bis 9, dadurch gekennzeichnet, daß der Balg (76) aus Metall, z.B. Tombak, Bronze oder Edelstahl, ist.

## Claims

1. Goniometer stage, preferably for electron microscopes, with a bearing sleeve (70) for accommodating a specimen holder rod (80), with a tilting device for tilting said bearing sleeve (70) and said specimen holder rod (80) about a tilt axis (45); the tilting device being made up of an inner bearing (21) with a ball-like end, with the inner bearing being located in objective lens block (20), and an outer bearing (37) on the microscope wall with a rotatable cylinder (40) rotatable about the cylinder axis (41); with adjustment of the cylinder (40) and of the tilt axis (45) being possible using adjusting devices (31-34), and with positioning devices (50, 60) for positioning a section of the object (15) which are rotatable together with the tilting device; characterized by the fact that the bearing sleeve (70) and the ball-like end of the inner bearing (21) are firmly connected; that the ball-like end is not rigidly connected to the cylinder (40) of the outer bearing (37), thereby ensuring that the adjustment of the cylinder (40) by means of the adjusting devices (31-34) is independent of the inner bearing (21); that the bearing sleeve (70) can be positioned about the center (22) of the ball-like end by the positioning devices (50, 60) and that the bearing sleeve (70) is connected with the rotatable cylinder (40) by means of torsion-resistant bellows (76).

2. Goniometer stage according to claim 1, characterized by the fact that the positioning devices (50, 60) for the Y and Z settings are independent of the tilt about the tilt axis (45) and of each other.

3. Goniometer stage according to claim 2, characterized by the fact that a mechanical stage guiding system (Fig. 3) is provided for the positioning devices (50, 60).

4. Goniometer stage according to one of the claims 1 to 3, characterized by the fact that the points of application of the positioning devices (50, 60) for the Y and Z settings on the bearing sleeve (70) are as close to the outer bearing (37) as possible.

5. Goniometer stage according to one of the claims 1 to 4, characterized by the fact that the specimen holder rod (80) is seated in a V-shaped bearing in the ball-like end of the bearing sleeve (70), and that a spring is provided for pressing the specimen holder rod (80) against the V-shaped bearing.

6. Goniometer stage according to one of the claims 1 to 5, characterized by the fact that the positioning device (90) for the X setting is adjustable to the tilt axis (45) on a spherical surface (9C), the center of which is coincident with the center (22) of the inner bearing (21).

7. Goniometer stage according to one of the claims 1 to 6, characterized by the fact that mechanical, piezoelectric, pneumatic drives or electromotorized drives (52, 62, 92) are provided for the positioning devices (50, 60, 90).

8. Goniometer stage according to one of the claims 1 to 7, characterized by the fact that counters, pulse transmitters or position transducers (53, 63, 93) are provided on the positioning devices (50, 60, 90) for the indication and storage of the coordinates of the set section of the specimen (15).

9. Goniometer stage according to claim 8, characterized by the fact that the positioning devices (50, 60, 90) and the position transducers (53, 63, 93) are connected to a control or regulating device.

10. Goniometer stage according to one of the claims 1 to 9, characterized by the fact that the bellows (76) are made of metal, e.g. tombac, bronze or stainless steel.

## Revendications

1. Platine de goniomètre, employée principalement sur les microscopes électroniques, munie d'un coussinet (70) où est logée une tige porte-objet (80), d'un mécanisme qui permet d'incliner le coussinet (70) avec la tige porte-objet (80) autour d'un axe (45) et comprend un palier interne (21) à rotule disposé dans le bloc d'objectif (20), ainsi qu'un palier externe (37) à cylindre (40) rotatif autour de l'axe (41), placé contre la paroi du microscope, le cylindre (40) et l'axe d'inclinaison (45) étant ajustables par ailleurs à l'aide des dispositifs (31-34), des dispositifs (50, 60) pour régler une coupe de l'objet (15), qui peuvent pivoter conjointement avec le mécanisme d'inclinaison, caractérisée par le fait que le coussinet (70) et la rotule sont assemblés fixement, que la rotule n'est pas raccordée rigidement avec le cylindre (40) du palier externe (37), que le cylindre (40) est ajusté à l'aide des dispositifs (31-34) indépendamment du palier interne (21), que le coussinet (70) peut pivoter au moyen des dispositifs (50, 60) autour du centre (22) de la rotule et que le coussinet (70) est relié avec le cylindre rotatif (40) par l'intermédiaire d'un soufflet (76) rigide à la torsion.

2. Platine de goniomètre conçue selon la spécification 1, caractérisée par le fait que les dispositifs (50, 60) de réglage des coordonnées y et z sont indépendants l'un de l'autre et de l'inclinaison autour de l'axe (45).

3. Platine de goniomètre conçue selon la spécification 2, caractérisée par le fait qu'une glissière de platine à mouvements croisés est prévue pour les dispositifs (50, 60).

4. Platine de goniomètre conçue selon les spécifications énoncées de 1 à 3, caractérisée par le fait que les points où les dispositifs (50, 60) de réglage des coordonnées y et z sont en contact avec le coussinet (70) se trouvent aussi près que possible du palier externe (37).

5. Platine de goniomètre conçue selon les spécifications énoncées de 1 à 4, caractérisée par le fait que la tige porte-objet (80) repose sur un palier en V à l'intérieur de la rotule du coussinet (70) et qu'un ressort sert à plaquer la tige porte-objet (80) contre le palier en V.

6. Platine de goniomètre conçue selon les spécifications énoncées de 1 à 5, caractérisée par le fait que le dispositif de réglage de la coordonnée x par rapport à l'axe d'inclinaison (45) est ajustable sur une surface sphérique (9C) dont le milieu est situé au centre (22) du palier interne (21).

7. Platine de goniomètre conçue selon les spécifications énoncées de 1 à 6, caractérisée par le fait que des commandes mécaniques, piézo-électriques, pneumatiques ou des commandes à moteur électrique (52, 62, 92) sont prévues pour les dispositifs de réglage (50, 60, 90).

8. Platine de goniomètre conçue selon les spécifications énoncées de 1 à 7, caractérisée par le fait que des compteurs, des générateurs d'impulsions ou des indicateurs de position (53, 63, 93) sont prévus au niveau des dispositifs de réglage (50, 60, 90) pour afficher et enregistrer les coordonnées de la coupe de l'objet (15) choisie.

9. Table de goniomètre conçue selon la spécification 8, caractérisée par le fait que les dispositifs de réglage (50, 60, 90) et les indicateurs de position (53, 63, 93) sont connectés à un système de commande ou de régulation.

10. Platine de goniomètre conçue selon les spécifications énoncées de 1 à 9, caractérisée par le fait que le soufflet (76) est fabriqué en métal (tombac, bronze ou acier inoxydable, par exemple). `

Fig.1

Fig.2

Fig.3

EP 0 226 804 B1